(19) Europäisches Patentamt

**European Patent Office**

Office européen des brevets

(11) Veröffentlichungsnummer: **0 240 820 B1**

(12) **EUROPÄISCHE PATENTSCHRIFT**

(45) Veröffentlichungstag der Patentschrift: 24.04.91

(21) Anmeldenummer: 87104222.2

(22) Anmeldetag: 23.03.87

(51) Int. Cl.5: **H03H 17/02**

(54) **Digitales Filter, das als zweidimensionales Wellendigitalfilter ausgebildet ist.**

(30) Priorität: 08.04.86 DE 3611759

(43) Veröffentlichungstag der Anmeldung:
14.10.87 Patentblatt 87/42

(45) Bekanntmachung des Hinweises auf die
Patenterteilung:
24.04.91 Patentblatt 91/17

(84) Benannte Vertragsstaaten:
**AT CH DE FR GB IT LI SE**

(56) Entgegenhaltungen:
**US-A- 4 061 905**

**1984 IEEE INTERNATIONAL SYMPOSIUM ON CIRCUITS AND SYSTEMS PROCEEDINGS, Montreal, 7.-10. Mai 1984, Band 3, Seiten 951-957, IEEE, New York, US; A. FETTWEIS: "Multidimensional circuit and systems theory"**

(73) Patentinhaber: **Siemens Aktiengesellschaft
Wittelsbacherplatz 2
W-8000 München 2(DE)**

(72) Erfinder: **Fettweis, Alfred, Prof. Dr.
Im Königsbusch 30
W-4630 Bochum(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein digitales Filter gemäß dem Oberbegriff des Patentanspruches.

In der Zeitschrift AEÜ, Band 25, 1971, Heft 2, Seiten 79 bis 89 sind digitale Filterstrukturen angegeben worden, die in Bezug gesetzt sind zu klassischen Filternetzwerken. Für diese spezielle Gattung von digitalen Filtern wird die Bezeichnung Wellendigitalfilter verwendet. Auch die Wellendigitalfilter bestehen dem Grundkonzept nach aus Addierern, Verzögerungsgliedern und Multiplizierern, haben jedoch die Eigenschaft, daß sie unmittelbar den klassischen Filtern nachgebildet werden können. Von den drei Typen von Komponenten, aus denen digitale Filter bestehen, tritt die Verzögerung nur in den Wellendigitalfilter-Gleichungen auf, die die klassischen reaktiven Elemente beschreiben, während die Zusammenschaltungen über sogenannte Adaptoren erfolgen. Diese Adaptoren bestehen aus Addierern und Multiplizierern. Auf diese Zusammenhänge ist auch in der DE-C- 20 27 303 hingewiesen, wo bereits die Grundstrukturen solcher Wellendigitalfilter beschrieben sind. In Weiterbildung dieses Gedankens ist in der DE-C- 26 39 568 darauf hingewiesen, solche Wellendigitalfilterstrukturen mehrdimensional auszubilden, insbesondere auch zweidimensional. In deisem Zusammenhang ist auch auf das Dokument "1984 IEEE Int. Symposium on Circuits and Systems Proceedings", Montreal, 7.-10 Mai 1984, Band 3, Seiten 951-957, IEEE, New York, US; A. Fettweis: "Multidimensional Circuit and Systems Theory" hinzuweisen. Es ist verständlich, daß die Anwendung solcher Filter in erheblichem Maß abhängt von der jeweils zur Verfügung stehenden Technologie. Der Fortschritt, der in der sogenannten VLSI-Technologie (very large scale integration) erzielt wird, bringt, gegenüber früheren komplizierten und verhältnismäßig langsamen Rechnern, realzeitmehrdimensionale Filter in den Bereich der praktischen Realisierung.

Der Erfindung liegt die Aufgabe zugrunde, ein zweidimensionales Wellendigitalfilter anzugeben, bei dem die Zahl der erforderlichen Schaltelemente (hardware) möglichst klein ist und unerwünschte Störungen, die durch die digitale Filtertechnik bedingt sind, möglichst klein bleiben.

Diese Aufgabe wird erfindungsgemäß durch die Merkmale des Patentanspruches gelöst.

Anhand von Ausführungsbeispielen wird nachstehend die Erfindung noch näher erläutert.

Es zeigen in der Zeichnung

Fig. 1a

eine einfache Zweitorschaltung mit einer Induktivität im Längszweig und einer Kapazität im Querzweig,

Fig. 1b

eine Schaltung bei der die zwei Tore durch sogenannte Einheitselemente realisiert sind,

Fig. 2

eine mögliche Form für eine Linie entlang der die Dämpfung konstant ist.

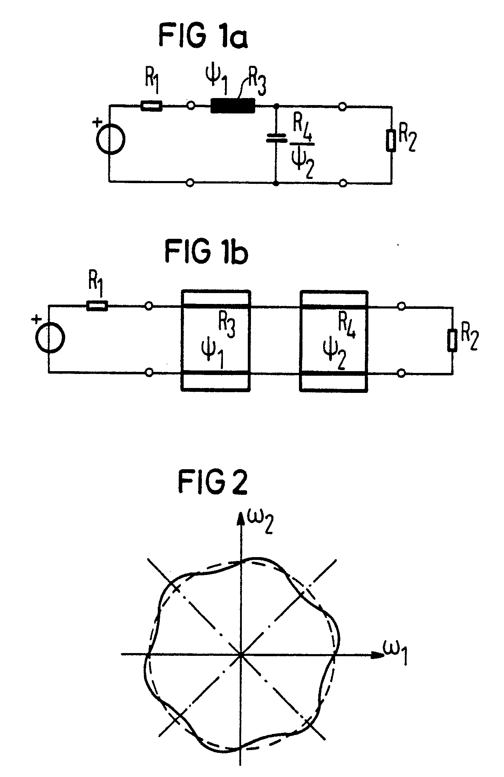

In den Fig. 1a und 1b ist zu erkennen eine Spannungsquelle, die an ihrem oberen Ende durch ein " + "-Zeichen kenntlich gemacht ist und der der Innenwiderstand $R_1$ zugeordnet ist. Der Abschlußwiderstand ist mit $R_1$ bezeichnet. Zwischen diesen beiden Widerständen befindet sich in Fig. 1a eine Zweitorschaltung, die im Längszweig aus einer Induktivität $\psi_1 R_3$ und im Querzweig aus einer Kapazität $R_4/\psi_2$ besteht. Kapazität und Induktivität können auch gegeneinander vertauscht werden.

In der Schaltung von Fig. 1b bestehen die zwei Tore aus sogenannten Einheitselementen, die in den ausgezogen umrandeten Blockschaltbildern mit $R_3$ und $\psi_1$ bzw. mit $R_4$ und $\psi_2$ kenntlich gemacht sind. Auf die mögliche Verwendung solcher Einheitselemente ist in der vorgenannten Literatur an sich bereits hingewiesen.

Hinsichtlich der physikalischen Wirkungsweise sei folgendes ausgeführt.

Es zeigt sich, daß der einfachste Weg, um ein zweidimensionales Tiefpaßfilter zu erhalten, das ein näherungsweise kreisförmiges Dämpfungserhalten hat, darin bestehen, von einer stabilen eindimensionalen Übertragungsfunktion auszugehen, auf die eine hinreichende Anzahl von Frequenztransformationen ($\psi$-Ebenen-Rotation) der Form

$$\psi = c_1 \psi_1 + c_2 \psi_2 \qquad (1)$$

angewendet wird, wobei $c_1$ und $c_2$ Konstanten sind und die resultierenden Teilfilter in Kette (Kaskade) zu schalten sind. Für ein k-dimensionales Filter ist folgendes zu beachten. Es ergeben sich k komplexe Frequenzen $p_i$, d.h. k äquivalente komplexe Frequenzen $\psi_i$

$$\psi_i = \tanh(p_i T_i/2) = (e^{p_i T_i} - 1)/(e^{p_i T_i} + 1)$$

und damit auch k entsprechende äquivalente reelle Frequenzen $\phi_i$,

$$\phi_i = \tan(\omega_i T_i/2), \quad i = 1 \text{ bis } k,$$

wobei im vorliegenden Fall $k = 2$ ist.

Der in Gleichung (1) angegebene Sachverhalt ist sofort auf Wellendigitalfilter anwendbar. Wenn nämlich $c_1 \geq 0$ und $c_2 \geq 0$, dann transformiert Gleichung (1) eine Induktivität mit der Impedanz $R\psi$ in zwei Induktivitäten in Serie von Impedanzen $c_1 R\psi_1$ und $C_2 R\psi_2$ und eine Kapazität mit der Impedanz $R/\psi$ in zwei parallelgeschaltete Kapazitäten mit den Impedanzen $R/c_1\psi_1$ und $R/c_2\psi_2$. Filterdrehungen und Winkel die anders als jene sind, die man mit $c_1 \geq 0$ und $c_2 \geq 0$ erreichen kann, lassen sich durch Datendrehung um 90° erreichen, während Phasenkompensationen in der Weise möglich sind, daß man die Daten in jedem Teil-Filter-Abschnitt zweimal bearbeitet, und zwar einmal in Vorwärtsrichtung und einmal in Rückwärtsrichtung. Diese Methode kann ferner dadurch vervollkommnet werden, daß man sogenannte triäquilaterale Abtastung benutzt, d.h. eine Abtastung entsprechend einem Raster von äquilateralen Dreiecken, was auch als sogenanntes hexagonales oder quincunxiales Abtasten bekannt ist.

Es wäre indessen besser, Bezugsfilter zur Verfügung zu haben, deren Übertragungsfunktionen möglichst unmittelbar das jeweils geforderte Dämpfungsverhalten haben. Obwohl bislang dafür keine analytische Lösung gefunden wurde, stehen Verfahren mit einer numerischen Optimierung zur Verfügung, und es kann ein geforderter Phasenausgleich schließlich noch durch Zufügen eines multidimensionalen Allpaß-Digitalfilters ermöglicht werden. Strukturen, die auf jeden Fall für den beabsichtigten Zweck geeignet sind, sind kreuzantimetrische Zweitore, d.h. Zweitore, bei denen die Streuparameter die folgenden Bedingungen erfüllen

$$S_{12}(\psi_1, \psi_2) = S_{21}(\psi_1, \psi_2) = S_{21}(\psi_2, \psi_1)$$

$$S_{22}(\psi_1, \psi_2) = -S_{11}(\psi_2, \psi_1)$$

Zwei einfache Beispiele solcher kreuzantrimetrischer Zweitore sind in den Fig. 1a und 1b gezeigt. Wie schon erwähnt, können in Fig. 1a die Kapazität und die Induktivität gegeneinander vertauscht werden, und Fig. 1b zeigt eine Struktur aus sogenannten Einheitselementen, die für sich aus der vorgenannten Literatur ebenfalls bekannt sind. Für die Schaltungen nach den Fig. 1a und 1b gilt die Beziehung

$$R_1/R_3 = R_4/R_2$$

Es muß festgestellt werden, daß solche Strukturen keine Quadranten-Symmetrie für die Dämpfung zeigen, wie dies häufig für digitale Filter gefordert wird. Eine volle Quadranten-Symmetrie ist jedoch keineswegs notwendig. Die kreuzantimetrischen Strukturen zeigen jedoch Symmetrie in Bezug auf die beiden Diagonalen. In Fig. 2 ist dies noch im einzelnen dargestellt. In einem rechtwinkeligen Koordinatensystem mit der Abszisse $\omega_1$ und der Ordinate $\omega_2$ ist gestrichelt zu erkennen ein Kreis. Dieser Kreis stellt die ideale Durchlaßbereich-Begrenzung dar, die in der Praxis jedoch nicht erreichbar ist. Die ausgezogen gezeichnete Kurve stellt die in der Praxis erreichbare Kurve für konstante Dämpfung dar, und diese Kurve ist symmetrisch zu den strichpunktiert eingetragenen Diagonalen. Durch diese Eigenschaft unterscheiden sich die im vorstehend beschriebenen kreuzantimetrischen Strukturen also ebenfalls von bekannten Strukturen.

Die vorstehend beschriebenen zweidimensionalen Wellendigitalfilter haben den Vorteil, daß sie ein beinahe kreisförmig symmetrisches Verhalten zeigen. Sie haben auch die gleichen Vorteile wie eindimensionale Wellendigitalfilter, weil eine große Zahl von klassischen Strukturen digital nachgebildet werden kann, so daß also anstehende Filterprobleme in der jeweils zweckmäßigsten Form gelöst werden können.

## Ansprüche

1. Digitales Filter, bestehend aus einer als zweidimensionales Wellendigitalfilter ausgebildeten Schaltung, die einen Eingang und einen Ausgang enthält und bei der das zweidimensionale Wellendigitalfilter aus Adierern, aus Verzögerungsgliedern mit der Verzögerung $T_i$, aus Multiplizierern und aus Adaptoren besteht, **dadurch gekennzeichnet,** daß die zwischen Eingang und Ausgang liegende Schaltung als kreuzantimetrische Zweitorschaltung ausgebildet ist, deren Streuparameter $S_{11}$, $S_{12}$, $S_{21}$, $S_{22}$ der Bedingung:

$$S_{12}(\psi_1, \psi_2) = S_{21}(\psi_1, \psi_2) = S_{21}(\psi_2, \psi_1)$$

$$S_{22}(\psi_1, \psi_2) = -S_{11}(\psi_2, \psi_1)$$

genügen, deren äquivalente komplexe Frequenzen $\psi_i$ definiert sind zu:

$$\psi_i = \tanh(p_i T_i/2) = (e^{p_i T_i} - 1) / (e^{p_i T_i} + 1),$$

mit den komplexen Frequenzen $p_i$, mit $i = 1, 2$.

## Claims

1. Digital filter, consisting of a circuit, which is constructed as a two-dimensional digital wave filter and contains an input and an output and in which the two-dimensicnal digital wave filter consists of adders, delay elements having a delay $T_i$, multipliers and adaptors, characterised in that the circuit lying between input and output is constructed as a cross-antimetrical two-port network, whose dispersion parameters $S_{11}$, $S_{12}$, $S_{21}$, $S_{22}$ satisfy the condition:

$$S_{12}(\psi_1, \psi_2) = S_{21}(\psi_1, \psi_2) = S_{21}(\psi_2, \psi_1)$$
$$S_{22}(\psi_1, \psi_2) = -S_{11}(\psi_1, \psi_2)$$

whose equivalent complex frequencies $\psi_i$ are defined to be:

$$\psi_i = \tanh(p_i T_i/2) = (e^{p_i T_i} - 1) / (e^{p_i T_i} + 1),$$

with the complex frequencies $p_i$, where $i = 1, 2$.

## Revendications

1. Filtre numérique, constitué par un circuit agencé sous la forme d'un filtre d'ondes numérique bidimensionnel, qui comporte une entrée et une sortie et dans lequel le filtre d'ondes numérique bidimensionnel est constitué par des circuits de retardement produisant le retard $T_i$, par des multiplicateurs et par des adaptateurs, caractérisé par le fait que le circuit situé entre l'entrée et la sortie est réalisé sous la forme d'un circuit en forme de porte double antisymétrique croisée, dont les paramètres de dispersion $S_{11}$, $S_{12}$, $S_{21}$, $S_{22}$ satisfont à la condition :

$$S_{12}(\psi_1, \psi_2) = S_{21}(\psi_1, \psi_2) = S_{21}(\psi_2, \psi_1)$$
$$S_{22}(\psi_1, \psi_2) = -S_{11}(\psi_2, \psi_1)$$

dont les fréquences complexes équivalentes $\psi_i$ sont définies par:

$$\psi_i = \tanh(p_i T_i/2) = (e^{p_i T_i} - 1)/(e^{p_i T_i} + 1),$$

avec les fréquences complexes $p_i$, avec i = 1, 2.

## FIG 1a

## FIG 1b

## FIG 2

6